**Europäisches Patentamt**

**European Patent Office**

**Office européen des brevets**

(19)

(11) **EP 1 426 823 A1**

(12) **EUROPEAN PATENT APPLICATION**

(43) Date of publication:
**09.06.2004 Bulletin 2004/24**

(51) Int Cl.⁷: $G03F\ 7/20$

(21) Application number: **02080031.4**

(22) Date of filing: **02.12.2002**

(84) Designated Contracting States:
**AT BE BG CH CY CZ DE DK EE ES FI FR GB GR
IE IT LI LU MC NL PT SE SI SK TR**
Designated Extension States:
**AL LT LV MK RO**

(71) Applicant: **ASML Netherlands B.V.**
**5503 LA Veldhoven (NL)**

(72) Inventors:
• **Mulder, Heine Melle**
**5625 SE Eindhoven (NL)**

• **Hoegee, Jan**
**5653 LN Eindhoven (NL)**
• **Kollen, Armand, Eugene, Albert**
**5658 HD Eindhoven (NL)**

(74) Representative:
**Prins, Adrianus Willem, Mr. Ir. et al
Vereenigde,
Nieuwe Parklaan 97
2587 BN Den Haag (NL)**

(54) **Lithographic apparatus, device manufacturing method, and device manufactured thereby**

(57)     In a lithographic projection apparatus angle dependence of the intensity distribution of a projection beam at substrate is controlled to attain a desired illumination effect. A beam splitter is permanently located in the beam near a pupil plane. The beam splitter splits off an auxiliary beam, which is used to measure information about the position dependence of the intensity distribution of the beam at the pupil plane. Preferably, the measured position dependence in the auxiliary beam is used deconvoluted to compensate for offset between the pupil plane and a detection element. The measured position dependence is used to control parameter of an optical element that manipulates the position dependence in the pupil plane. An example of such an optical element is a matrix of elements that controllable steer the direction of parts of the beam. Thus a continuous feedback loop may be realized.

Fig. 2

EP 1 426 823 A1

## Description

The present invention relates to a lithographic projection apparatus comprising:

- a radiation system for providing a projection beam of radiation, the radiation system comprising an illuminating system for defining a position dependent intensity distribution of the beam in a pupil plane;
- a support structure for supporting patterning means, the illuminating system defining an angle dependent intensity distribution of the beam at the patterning means dependent on the position dependent intensity distribution in the pupil plane;
- a substrate table for holding a substrate; and
- a projection system for projecting the patterned beam onto a target portion of the substrate,

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

The radiation system has to ensure the realization of a desired intensity distribution as a function of position across the beam and as a function of angle of incidence of different rays in the beam at the substrate. The desired position dependence, excluding mask generated patterns, generally has to be uniform with constant intensity as a function of position on the substrate, and the desired angle dependence has to peak at certain angles. The desired angle dependence may depend the nature of the pattern on the mask. Therefore it has to be possible to change the spatial properties of the illumination of the mask, so that the appropriate desired properties can be realized. Very complex illuminating systems are to ensure realization of the desired properties.

European Patent application 1304850.9 (and also in EP 02253823.5 and corresponding US application No. 10/157,033 assigned to the same assignee as the present application and having common inventors), which is incorporated herein by way of reference, describes examples of such an illuminating system. One illuminating system has a laser source, followed by an optical element such as a Diffraction Optical Element (DOE), an axicon and a zoom lens. Following the DOE axicon and zoom lens the beam passes through a rod with reflective side walls. The rod evenly smears out the intensity distribution as a function of position, conserving most of the angle dependence.

The DOE, axicon and zoom lens are used to shape the angle dependent intensity distribution of the projection beam at the substrate ("angle" in this context may refer to the angle relative to the main direction of the beam, as well as to an angle rotated around that main direction). As an alternative to at least the DOE an matrix of individually, electronically orientable micro-mirrors or micro-lenses has been proposed. By controlling the fractions of mirrors that reflect the beam in various directions very detailed control of the angle dependent intensity distribution is made possible. It has also been proposed to perform the function of the axicon by a DOE.

Such a highly complex illuminating system has to be accurately configured to ensure the desired uniformity and intensity distribution as a function of angle at the substrate. Small deviations in the illuminating system may affect the intensity distribution. Even erratic factors, such as contamination may be of importance.

Currently, the correct intensity distribution is generally ensured by a set-up procedure, which involves choosing the components needed for illumination with a particular mask and adjustment of the parameters of these components prior to illumination of the substrate, to ensure that the desired intensity distribution as a function of position and angle will be realized. The parameters involve for example the distance between the elements of the axicon and/or the orientation of the mirrors in the matrix of mirrors.

It has proved possible to measure the position dependence of the intensity distribution at the substrate. For this purpose a detector may be included near the substrate, or near the mask, were there is usually sufficient space for such a detector.

Measurement of the angle distribution is less straightforward. In principle the angle distribution can be measured with position dependent intensity detection in or near a pupil plane, that is, inside the optical system rather than at its output as in the case of measurement of position dependence at the substrate. Thus, the normal imaging process must be interrupted. The relation between a pupil plane and the plane of the mask is that the intensity distribution as a function of position in the pupil plane determines the intensity distribution as a function of angle at the mask. Vice versa the intensity distribution as a function of angle in the pupil plane determines the intensity distribution as a function of position at the mask (although the latter relation is generally destroyed in a lithographic apparatus by passing the projection beam through an internally reflecting rod). This relation arises because between the pupil plane and the mask an optical structure is included with an effective focal distance so that the pupil plane at the effective focal distance from the optical structure.

Measurement of position dependence at the pupil plane currently involves an interruption of the normal operable set-up of the apparatus, because it involves putting a detector into the pupil plane. In the set-up for normal operation many components of the illuminating system generally crowd the space in the vicinity of the pupil plane, for example because they are needed to control the illumination pattern at the pupil plane.

After checking the intensity distribution at the pupil plane with the detector and adjusting the parameters of the optical components that affect the intensity distribution in the pupil plane, the apparatus is restored to normal operating order so that the beam can reach the substrate. The optical components that affect intensity distribution in the pupil plane are subsequently left as set-up to retain the required angle dependence.

This procedure has the disadvantage that it increases the time before the apparatus can be used after a change of mask. Moreover, it excludes dynamic control over the angle dependent intensity distribution of the illumination of the substrate.

It is an object of the present invention to make it possible to measure information about the intensity distribution in the pupil plane without disrupting operability of the apparatus.

It is an object of the present invention to make it possible to adjust the configuration of the illuminating system at any time to control a desired intensity distribution in the pupil plane dependent on measured information about the intensity distribution.

It is a further object of the present invention to make it possible to measure information about the intensity distribution in the pupil plane without taking up space used by components close to the pupil plane that constructively affect the intensity distribution in the pupil plane.

This and other objects are achieved according to the invention in a lithographic apparatus as specified in the opening paragraph, characterized by the characterizing portion of claim 1. Instead of a detector that has to be moved in and out of the projection beam of the lithographic apparatus to obtain information about the intensity distribution in the pupil plane, a permanent arrangement is used, with a beam splitter that splits off an auxiliary beam from the projection beam. Information about the intensity distribution of the projection beam in the pupil plane is obtained from measurements in the auxiliary beam.

The information obtained from the intensity distribution across the auxiliary beam may be used to adjust the optical components that are used to manipulate the position dependence of the intensity distribution in the pupil plane. Thus, for example, the fraction of mirrors in the matrix that reflect the projection beam in a certain direction may be modified so that the measured distribution more closely approaches the required distribution. The axicon may be adjusted to change the diameter of a ring of light in the pupil plane, or the zoom factor of the zoom lens may be adjusted etc, all dependent on information from the measurements of the intensity distribution in the auxiliary beam.

Preferably a feedback loop from the detector is used for this purpose. Because the beam splitter is permanently in the beam control over the angle dependence is thus permanently possible. This makes it possible to use dynamic control over the angle dependence during illumination of a substrate. Also rapid changes of the desired intensity distribution can be realized.

Preferably, one or more set values of the information are provided, which define at least part of the desired illumination pattern for the mask in current use in the lithographic apparatus, and parameters of the optical components are controlled to change the measured value of the information toward the set values.

Control over the angle dependence of the intensity distribution of the beam at the substrate may be combined with control over the position dependent intensity distribution of the beam at the substrate. For the latter, a second intensity detector is preferably used at the substrate or the mask . Thus at least two feedback loops control the intensity distribution of the beam, each with a detector located at a different position with respect to the beam.

To reserve as much space as possible for optical elements that manipulate the intensity distribution, the location of the detection element in the auxiliary beam is preferably not exactly in the pupil plane. As a result there is generally a discrepancy between the intensity measured across the auxiliary beam and the distribution across the pupil plane. A deconvolution operation is preferably applied to the measurements of the intensity across the auxiliary beam to compensate for this discrepancy. The deconvolution is preferably performed using a suitably programmed computer, which processes information obtained from the measurements.

The detector may be realized by using a partially transparent mirror surface which reflects a portion of the projection beam, with a detector attached to a rear side of the mirror surface. The detector may include a CCD sensor matrix, if necessary preceded by a fluorescent layer to generate signal detectable for the CCD. By placing the detector, or at least the fluorescent layer substantially immediately behind the mirror the discrepancy between the intensity distribution at the pupil plane and at the detector is minimized.

In the illuminating system of known lithographic apparatuses the pupil plane may be followed by a coupling lens, a light homogenizing rod and a condenser lens in the path of the beam before the mask. The rod more evenly distributes the intensity distribution as a function of position on the mask, while maintaining at least part of the angle dependence. In the condenser lens behind the rod a second pupil plane arises before the beam reaches the mask. In an embodiment the beam splitter is located in the path of the projection beam substantially immediately following the condenser lens. It has been found that this location ensures useable detection information, without disrupting the illumination system in such a way that control over the intensity distribution is diminished.

In another embodiment, the beam splitter is located preceding the pupil plane that has been mentioned, between the optical structure that shapes the angle dependence (including for example the matrix of mirrors, the DOE, the axicon and/or the zoom lens). This position makes it possible to locate the detector at a plane in the auxiliary beam that is equivalent to the pupil plane of the projection beam. Thus less discrepancy needs to arise between the detected intensity distribution and the actual intensity distribution.

A device manufacturing method comprising the steps of:

- providing a substrate that is at least partially covered by a layer of radiation-sensitive material;
- providing a projection beam of radiation using a radiation system, the radiation system comprising an illuminating system for defining a position dependence of an intensity distribution of the projection beam in a pupil plane, the position dependence determining an angle dependence of the intensity distribution of the projection beam at the substrate;
- using patterning means to endow the projection beam from the pupil plane with a pattern in its cross-section; and
- projecting the patterned beam of radiation onto a target portion of the layer of radiation-sensitive material,

    characterized by

- splitting off an auxiliary beam from the projection beam;
- measuring an intensity distribution across the auxiliary beam;
- controlling an intensity distribution at the pupil plane dependent on the intensity distribution measured across the auxiliary beam.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:

    Figure 1 depicts a lithographic projection apparatus according to an embodiment of the invention;
    Figure 2 schematically shows an embodiment of an optical path
    Figure 2a schematically shows an detail of an optical path
    Figure 3 schematically shows another embodiment of an optical path

Embodiment 1

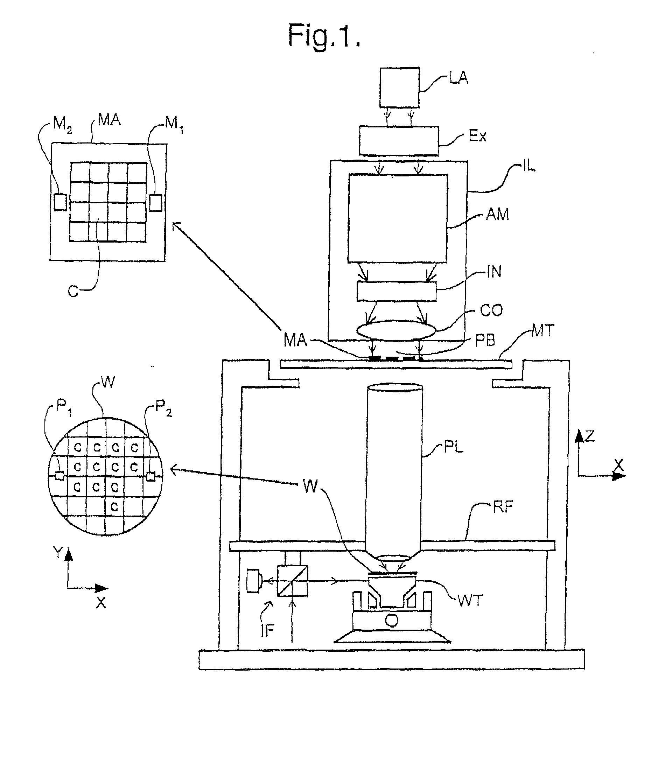

Figure 1 schematically depicts a lithographic projection apparatus 1 according to a particular embodiment of the invention. The apparatus comprises:

- a radiation system Ex, IL, for supplying a projection beam PB of radiation (e.g. ultraviolet radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e. g. a resist-coated silicon wafer), and connected to second positioning means PW for accurately positioning the substrate with respect to item PL; and

- a projection system ("lens") PL (e.g. a refractive lens) for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA (e.g. a laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks PI, P2.

The depicted apparatus can be used in two different modes:

> 1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
> 2. In scan mode, essentially the same scenario applies, except that a given target portion C is not exposed in a single "flash". Instead, the mask table MT is movable in a given direction (the so-called "scan direction", e.g. the y direction) with a speed *v*, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

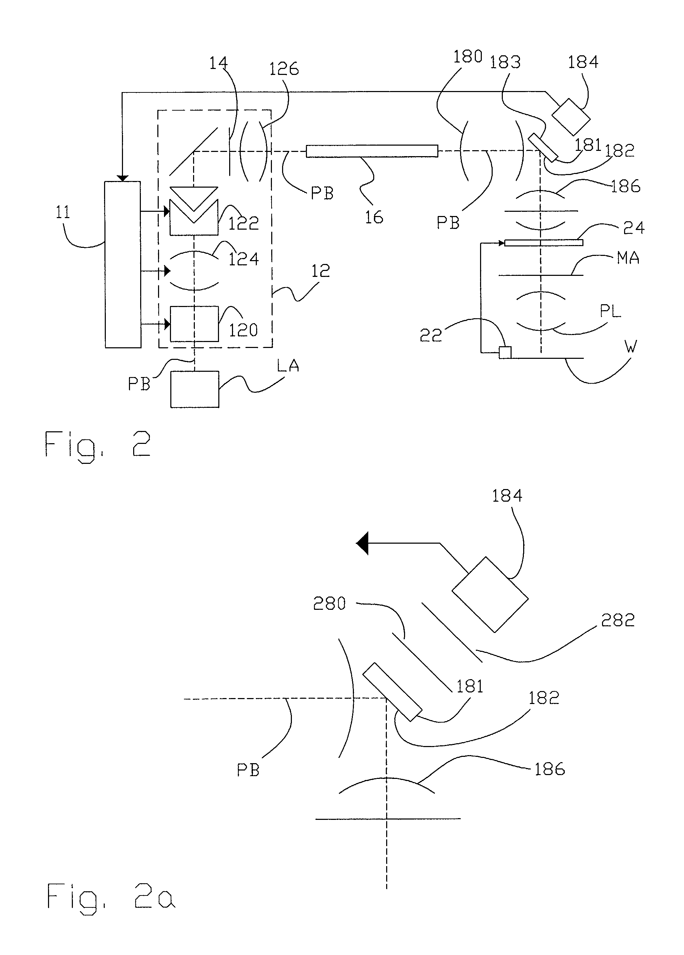

Figure 2 shows a more detailed schematic view of an embodiment of the optical path of the lithographic apparatus, including the illumination system. Beam PB is indicated by a dashed line. Beam PB passes from radiation source LA through an angular dependence shaping unit 12, a rod 16, first condenser lens 180, second condenser lens 186, position dependence control unit 24, mask MA, projection lens PL onto substrate W. A position dependent intensity detector 22 is included near substrate W, with an output coupled to position dependence control unit 24 (for correcting field plane non-uniformity at the mask MA). Here and in the following the word "lens" should be understood as a general term, referring not just to a single piece of optically shaped glass, but more generally including various types of optically active systems, including refractive optics, reflective optics, and catadioptric systems, composed of a single element or of a combination of elements.

In the path of beam PB a beam splitter 181 has been inserted in the form of a mirror whose front surface 182 reflects a majority of the beam PB, passing a fraction of the beam as an auxiliary beam to the back surface of the mirror, on which a detection element in the form of a fluorescent sheet 183 has been provided. A position dependent sensor 184 in the form of a CCD camera is pointed at fluorescent sheet 183. Sensor 184 is coupled to an input of a control unit 11, which has an output coupled to angular dependence shaping unit 12. By way of example angular dependence shaping unit 12 is shown to contain a first shaping element 120, a zoom lens 124 and an axicon 122. First shaping element contains for example an array of micro mirrors, that each reflect part of the beam in a controllable direction. Angular dependence shaping unit 12 produces an intensity distribution with a controlled position dependence at a pupil plane 14. A coupling lens 126 coupled the beam from pupil plane 14 into rod 16.

In operation the optical elements preceding pupil plane serve to manipulate the position dependence of the intensity distribution as a function of position in pupil plane 14. Optical elements 126, 180, 186 following pupil plane convert the position dependence into an angle of incidence dependence of the intensity of beam PB at mask MA and, via projection lens 20 at substrate W. The angle dependence of the intensity distribution at pupil plane 14 results in a position dependence of the intensity distribution of beam PB at mask MA, but only after being smeared out by rod 16, so that a substantially uniform position dependence occurs at mask MA.

In first condenser lens 180 an image of pupil plane 14 occurs (in fact a plurality of overlapping images of pupil plane 14, as a result of reflections in rod 16). Beam PB radiation emerging from this second pupil plane passes to semi-transparent mirror 181, through which a fraction (e.g. 1%) of the radiation is passed to fluorescent layer 183 at the back surface of mirror 181. Radiation impinging on fluorescent layer 183 gives rise to a position dependent light pattern at fluorescent layer 183. Sensor 184 measures the 2-dimensional position dependence of this pattern. Sensor 184 passes measured information about this pattern to control unit 11.

Control unit 11 uses the information to control parameters of one or more of the optical elements 120, 122, 124 that manipulate the position dependence of the intensity distribution in pupil plane, so as to make the position dependence fit a predetermined pattern that has been selected for a particular mask MA that is used to pattern beam PB.

In one example, first shaping element 120 contains a matrix of mirrors with each with an individually electronically controllable orientation. The orientation affects the direction of reflection of part of the beam. Optical elements such as zoom lens 124 between this matrix and pupil plane 14 convert the direction into illumination of direction dependent locations in pupil plane.

In this example controller 11 uses the measured position dependence to control orientation of the mirrors. Prior to processing controller 11 may normalize the measured intensity and the pattern with respect to one another so that their spatial averages are equal to each other. Controller 11 determines areas in the pupil plane over which the measured intensity exceeds the predetermined pattern. Controller 11 then computes a required reduction in the number of mirrors that reflect radiation from beams PB into those areas so that the intensity over these areas will be reduced to the intensity according to the predetermined pattern. Subsequently controller 11 sends control signals to first shaping element 120 to redirect a corresponding number of the mirrors that previously reflected radiation into these areas. Controller 11 may treat areas over which the predetermined pattern exceeds the measured intensity in the opposite way, controlling an increased number of mirrors to reflect the patterned beam into those area.

More generally, controller 11 may compute the redirection by searching for some matrix of redirection angles for the matrix of mirrors, so as to minimize a distance criterion between the predetermined pattern and a predicted effect of the matrix of redirection values.

In other examples, controller may control the distance between the elements of axicon 122 and/or the zoom factor of zoom lens 124 dependent on the measure intensity. The zoom factor may be controlled for example dependent a weighted average of the measured intensity, averaged over different positions in the pupil plane weighted with increasing weight as a function of the distance from the centre of zoom magnification. Dependent on whether the weighted average is above or below a reference value, the zoom factor is decreased or increased. A similar average, with weights changing from positive to negative near an edge in a required ring in the illumination pattern in the pupil plane, may be used to control axicon 122.

Instead of a matrix of mirrors a matrix of refractive elements (e.g. micro-lenses) may be used, or some form of position dependent control (a matrix of elements with controllable transmissivity) near pupil plane 14.

In the embodiment of figure 2 the detecting element (fluorescent layer 183) is close to an image plane of pupil plane 14 in first condenser lens 180 (here the word "image plane" is used in the sense that the optical distances between the pupil plane 14 and the image plane and the various optical elements in between correspond to an imaging relationship, although of course reflection in rod 16 has the effect of adding a number of mirror images of pupil plane 14). Placing the detection element in this way after rod 16 in the path op beam PB has the advantage that any effect of rod 16 on the angle dependence of the intensity distribution at mask MA can be corrected by controller. Because the image of the pupil plane generally occurs within the system of lenses that makes up first condenser lens 180 it is generally impossible to locate the detecting element permanently exactly in the image of pupil plane 14.

As a result certain discrepancies may occur between the position dependent intensity distribution in the image of the pupil plane and the detected intensity distribution. Preferably, controller 11 corrects these discrepancies before using the intensity distribution to control parameters of one or more of optical elements 120, 122, 144 angular dependence shaping unit 12. Correction involves deconvolution of the optical effect of the displacement between the image of pupil plane 14 and detection element 183. The intensity distribution $I(x, y)$ in the image of the pupil plane 14 may be related in good approximation to the intensity distribution $V(x', y')$ in the plane of detection element 183 by

$$V(x', y') = \text{integral over } x \text{ and } y \text{ of } H(x'-x, y'-y)*I(x, y)$$

Methods of inverting ("deconvoluting") this type of relation, i.e. estimating I(x,y) from measurement of V(x', y') are known per se (including e.g. dividing the Fourier transform of V by that of H). Controller 11 may use any such method to obtain an estimate of I(x,y) for use in controlling the parameters of the optical elements in angular dependence shaping unit 12.

For improved accuracy in deconvolution use may be made of the fact that the angle dependence of the intensity distribution at the image of pupil plane 14 is substantially uniform, since beam PB has been passed through rod 16 before forming the image. In a further embodiment controller may also receive information about the intensity distribution as a function of position at mask MA or substrate W, in this embodiment controller uses this information to correct the deconvolution for the angle dependence of the intensity distribution at the image of pupil plane 14.

Figure 2a shows a detail of a modified version of the optical path of figure 2. In this modified version, one or more additional optical elements 280 are included behind mirror 181 followed by a detection element 282. In this embodiment the detection element is not included immediately at the back surface of mirror 181. The additional optical element or elements 280 may be used to correct optically for the effect of displacement between the pupil plane and the detection element (e. g. by creating another image of the pupil), or at least to make correction for this effect easier to implement.

In yet another version (not shown), the detector contains an intransparent element with one or more transparent pinholes may be used between mirror 181 and the detection element, so that the pinholes are movable in a plane of transverse to the auxiliary beam direction. The intransparent element may be included substantially at the back surface of mirror 181 or behind optical element 280. In operation, the pinhole is moved, which causes the detection element to detect the intensity of the auxiliary beam at the position of the pinhole. In addition an angle dependency may be measured of the intensity of the light passing through the pinhole, by detecting the intensity at some distance behind the pinhole as a function of position transverse to the beam direction.

Controller 11 may be implemented as a suitable programmed computer which processes data from sensor 184 and sends out control signals to angular dependence shaping unit 12. Optionally, part of the processing, such as deconvolution may be executed by a digital signal processor (not shown). Controller preferably has an input, for example via a local area network, to receive information about the mask MA inserted in beam PB, or more particularly about the type of angle dependence of the intensity distribution at mask MA that is desired for that particular mask. A new desired angle dependency may be selected each time when the mask is changed.

Dependent on the embodiment controller 11 may be active to control angular dependence shaping unit 12 part of the time. In a first embodiment, controller 11 controls angular dependence shaping unit 12 dependent on data from sensor 184 only after mask MA has been changed, but before any relevant substrate W is illuminated. After capturing an appropriate setting of the parameters of angular dependence shaping unit 12, this setting is frozen during subsequent illumination of one or more substrates W. In a second embodiment, controller keeps controlling angular dependence shaping unit 12 dependent on data received during illumination of substrate W as well. Thus dynamic real-time control of the angle dependence is realized, which may be used to compensate for disturbances during illumination.

In a third embodiment controller 11 may change the desired angle dependence during illumination of a substrate, or between flashes of illumination of the same substrate in order to illuminate the substrate with radiation with successively angle dependent intensity distribution. Thus more accurately controllable illumination may be realized, avoiding for example interference effects between radiation incident from different angles, by illuminating from these angles successively. Because of the permanent detection of the pupil shape such control can be realized accurately and quickly.

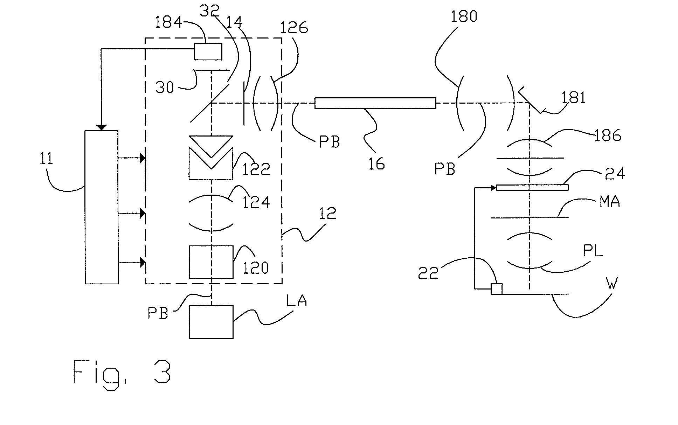

Figure 3 schematically shows the light path of a different embodiment of the lithographic apparatus. Here, detecting element 30 and sensor 184 have been placed behind a semi-transparent mirror 32 that precedes pupil plane 14 in the path of beam PB. Preferably detecting element 30 (for example a fluorescent sheet) is placed at a distance from mirror 32, so that the optical distance from mirror 32 to pupil plane 14 substantially equals the distance from mirror to detection element. Thus, no deconvolution is needed. However, detection element may also be provided at the back of mirror 32. In this case deconvolution may be needed, dependent on the distance to pupil plane 14 and the required accuracy. Similarly, optical elements (not shown) may be included behind mirror 32 to realize a more accurate pupil image at a desired distance from mirror 32.

Sensor 184 in the embodiment is preferably a conventional CCD camera, with a lens that demagnifies the size of detection element 30, 183 to the size of the CCD chip . However, if a sensor array of sufficient size is available to spread across the beam diameter, the sensor array may be included immediately behind detection element 183, 30. When sensor 184 is sensitive to radiation at the wavelength of beam PB, the separate detection element 183, 30 may even be omitted.

Whilst specific embodiments of the invention have been described above, it will be appreciated that the invention may be practiced otherwise than as described. The description is not intended to limit the invention. For example, although use of a mirror has been shown which reflects the main beam and transmits the auxiliary beam, it will be understood that alternatively a mirror may be used that transmits the main beam and reflects the auxiliary beam. In this case, of course, the detection element is preferably not included immediately on the mirror, but at some distance from it, so as not to hinder the main beam.

**Claims**

1. A lithographic projection apparatus comprising:

   - a radiation system for providing a projection beam of radiation, the radiation system comprising an illuminating system for defining a position dependent intensity distribution of the beam in a pupil plane;
   - a support structure for supporting patterning means, the illuminating system defining an angle dependent intensity distribution of the beam at the patterning means dependent on the position dependent intensity distribution in the pupil plane;
   - a substrate table for holding a substrate; and
   - a projection system for projecting the patterned beam onto a target portion of the substrate,

   **characterized in that** the apparatus comprises

   - a beam splitter permanently in a path of the projection beam, the beam splitter splitting off an auxiliary beam, and
   - a detector with a detection element in a path of the auxiliary beam for detecting information about a position dependent intensity distribution corresponding to the pupil plane.

2. A lithographic projection apparatus according to Claim 1, comprising a optical element with a controllable parameter and a controller having an input coupled to said detector and an output coupled to the optical element for controlling said parameter dependent on the detected information.

3. A lithographic projection apparatus according to Claim 2, the controller having an interface for receiving a selection of a desired position dependence of the intensity distribution at the pupil plane, the controller being arranged to regulate the parameter so as to approximate the desired position dependence.

4. A lithographic projection apparatus according to Claim 2 or 3, wherein the optical element comprises a matrix of elements, each reflecting or refracting the projection beam in a respective individually controllable direction, the controller being arranged to adapt a fraction of the elements that reflect or refract the beam to an area in said pupil plane dependent on discrepancy between a desired and a measured intensity over said area.

5. A lithographic projection apparatus according to any one of Claims 2 to 4, wherein the controller is arranged to control the parameter dependent on the measured position dependence at least during illumination of a substrate.

6. A lithographic projection apparatus according to any one of the preceding Claims, wherein the beam splitter is located at an offset from the pupil plane in the path of the projection beam, the detection element being arranged to detect an intensity distribution across the auxiliary beam, the apparatus comprising a deconvolution unit for deconvoluting a discrepancy between the intensity distributions at the pupil plane and at the detection element due to propagation along a sub-path from the pupil plane to the detection element.

7. A lithographic projection apparatus according to any one of the preceding Claims, wherein the beam splitter comprises a mirror surface that reflects a portion of the projection beam, the mirror surface transmitting a further portion of the projection beam as the auxiliary beam, the detection element intercepting the auxiliary substantially at a back side of the mirror surface.

8. A lithographic projection apparatus according to any one of the preceding Claims, wherein the beam splitter comprises a mirror surface that reflects a portion of the projection beam, the mirror surface transmitting a further portion of the projection beam as the auxiliary beam, the detection element intercepting the auxiliary following the mirror surface, a correction optical element or optical elements being included between the mirror surface and the detection element.

9. A lithographic projection apparatus according to any one of the preceding Claims, comprising an initial pupil plane, a light conducting rod with reflecting side walls for smearing out position dependence of the intensity distribution of the beam at the substrate, the rod being included in the path of the projection beam between the initial pupil plane and the first mentioned pupil plane, together with one or more optical elements for imaging the initial pupil plane onto the first mentioned pupil plane, the beamsplitter being located following the rod in the part of the beam.

10. A lithographic projection apparatus according to any one of the preceding Claims, wherein the beam splitter is located in the path of the beam preceding the pupil plane.

11. A device manufacturing method comprising the steps of:

    - providing a substrate that is at least partially covered by a layer of radiation-sensitive material;
    - providing a projection beam of radiation using a radiation system, the radiation system comprising an illuminating system for defining a position dependence of an intensity distribution of the projection beam in a pupil plane, the position dependence determining an angle dependence of the intensity distribution of the projection beam at the substrate;
    - using patterning means to endow the projection beam from the pupil plane with a pattern in its cross-section; and
    - projecting the patterned beam of radiation onto a target portion of the layer of radiation-sensitive material,

    **characterized by**

    - splitting off an auxiliary beam from the projection beam;
    - measuring an intensity distribution across the auxiliary beam;
    - controlling an intensity distribution at the pupil plane dependent on the intensity distribution measured across the auxiliary beam.

12. A device manufacturing method according to Claim 11, wherein a selection of a desired position dependence of the intensity distribution at the pupil plane is received, a parameter of the illuminating system being used in a feedback loop under control of the measured position dependence so as to make the position dependence of the intensity distribution of the beam approximate the desired position dependence.

13. A device manufacturing method according to Claim 12, wherein the illuminating system comprises a matrix of elements, each reflecting or refracting the projection beam in a respective individually controllable direction, the method comprising adapting a fraction of the elements that reflect or refract the beam to an area in said pupil plane dependent on discrepancy between a desired and a measured intensity over said area.

14. A device manufacturing method according to any one of Claims 11 to 13, wherein the controller is arranged to control the parameter dependent on the measured position dependence during illumination of the layer of radiation-sensitive material.

15. A device manufacturing method according any one of Claims 11 to 14, wherein the auxiliary beam is split off from the projection beam at a location at an offset from the pupil plane in the path of the projection beam, measuring comprising measuring the intensity distribution at a surface across the auxiliary beam, and deconvoluting a discrepancy between the intensity distributions at the pupil plane and said surface due to propagation along a sub-path between the pupil plane to the detection element.

16. A device manufacturing method according any one of Claims 11 to 15, wherein said splitting step is performed using a partially transparent mirror surface from which a portion of the projection beam is reflected, a further portion of the projection beam forming the auxiliary beam, which is intercepted substantially at a back surface of said mirror surface for detection of the intensity distribution.

17. A device manufacturing method according any one of Claims 11 to 16, comprising homogenizing a property of the projection beam that affect position dependence of the intensity distribution at the substrate, said auxiliary beam being split off after homogenizing.

18. A device manufacturing method according any one of Claims 11 to 17, comprising regulating a position dependence of the intensity distribution of the projection beam at the substrate in parallel with regulating the position dependence at the pupil plane.

# Fig.1.

Fig. 2

Fig. 2a

Fig. 3

**European Patent Office**

## EUROPEAN SEARCH REPORT

Application Number

EP 02 08 0031

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 040 894 A (TAKAHASHI KAZUHIRO) 21 March 2000 (2000-03-21) * figures 6,14 * * column 3, line 14 - line 50 * * column 7, line 52 - column 8, line 11 * * column 9, line 23 - line 47 * --- | 1-3,5,7, 8,11,12 | G03F7/20 |
| X | EP 0 526 242 A (CANON KK) 3 February 1993 (1993-02-03) * column 14, line 45 - column 15, line 5; figure 4 * --- | 1,11 | |
| X | US 5 684 567 A (SHIOZAWA TAKAHISA) 4 November 1997 (1997-11-04) * column 4, line 28 - line 41; figure 1 * --- | 1,11 | |
| A | EP 0 949 541 A (ASM LITHOGRAPHY BV) 13 October 1999 (1999-10-13) * the whole document * --- | 1 | |
| A | EP 0 687 956 A (ZEISS CARL ;ZEISS STIFTUNG (DE)) 20 December 1995 (1995-12-20) * the whole document * ----- | 1 | TECHNICAL FIELDS SEARCHED (Int.Cl.7)  G03F |

The present search report has been drawn up for all claims

| Place of search | Date of completion of the search | Examiner |
|---|---|---|
| MUNICH | 19 September 2003 | Eisner, K |

**ANNEX TO THE EUROPEAN SEARCH REPORT
ON EUROPEAN PATENT APPLICATION NO.**                    EP 02 08 0031

This annex lists the patent family members relating to the patent documents cited in  the above-mentioned European search report.
The members are as contained in the European Patent Office EDP file on
The European Patent Office is in no way liable for these particulars which are merely  given for the purpose of information.

19-09-2003

| Patent document cited in search report | | Publication date | Patent family member(s) | | Publication date |
|---|---|---|---|---|---|
| US 6040894 | A | 21-03-2000 | JP | 10135123 A | 22-05-1998 |
| EP 0526242 | A | 03-02-1993 | JP | 5036586 A | 12-02-1993 |
| | | | DE | 69207106 D1 | 08-02-1996 |
| | | | DE | 69207106 T2 | 15-05-1996 |
| | | | DE | 69230443 D1 | 20-01-2000 |
| | | | DE | 69230443 T2 | 18-05-2000 |
| | | | EP | 0526242 A1 | 03-02-1993 |
| | | | EP | 0614097 A1 | 07-09-1994 |
| | | | KR | 9608501 B1 | 26-06-1996 |
| | | | US | 5608575 A | 04-03-1997 |
| | | | US | 5631773 A | 20-05-1997 |
| US 5684567 | A | 04-11-1997 | JP | 2946950 B2 | 13-09-1999 |
| | | | JP | 6013289 A | 21-01-1994 |
| | | | AT | 196018 T | 15-09-2000 |
| | | | DE | 69329317 D1 | 05-10-2000 |
| | | | EP | 0576297 A1 | 29-12-1993 |
| | | | US | 5459547 A | 17-10-1995 |
| EP 0949541 | A | 13-10-1999 | EP | 0949541 A2 | 13-10-1999 |
| | | | JP | 2000058441 A | 25-02-2000 |
| | | | TW | 419422 B | 21-01-2001 |
| | | | US | 2002167653 A1 | 14-11-2002 |
| | | | US | 2001046038 A1 | 29-11-2001 |
| EP 0687956 | A | 20-12-1995 | DE | 4421053 A1 | 21-12-1995 |
| | | | DE | 4441947 A1 | 30-05-1996 |
| | | | DE | 59507458 D1 | 27-01-2000 |
| | | | EP | 0687956 A1 | 20-12-1995 |
| | | | JP | 8006175 A | 12-01-1996 |
| | | | US | 5675401 A | 07-10-1997 |

EPO FORM P0459

For more details about this annex : see Official Journal of the European Patent Office, No. 12/82